# EUROPEAN PATENT APPLICATION

(11) **EP 4 679 172 A1**
(43) Date of publication of application: **14.01.2026**
(21) Application number: 23950646.2
(22) Date of filing: 28.08.2023
(51) Int. Cl.: G03F 7/004

(54) **METHOD FOR PRODUCING PHOTOSENSITIVE ELEMENT, PHOTOSENSITIVE ELEMENT, METHOD FOR FORMING RESIST PATTERN, AND METHOD FOR PRODUCING PRINTED WIRING BOARD**

(71) Applicant: Resonac Corporation, Tokyo 105-7325 (JP)
(72) Inventor: TODA, Natsuki, Tokyo 105-7325 (JP); YOSHIHARA, Kensuke, Tokyo 105-7325 (JP); KAGUCHI, Yosuke, Tokyo 105-7325 (JP)
(74) Representative: Berggren Oy
(86) International application number: PCT/JP2023/030958
(87) International publication number: WO 2025/046694

(57) **Abstract**

A method for producing a photosensitive element includes a step of forming a photosensitive layer on a support film by using a photosensitive resin composition, in which in a case where a surface of the support film opposite to a surface of the support film on which the photosensitive layer is formed is defined as a first surface, and the surface of the support film on which the photosensitive layer is formed is defined as a second surface, a surface roughness Sq₁ of the first surface is 4.0 nm or less, and a total value of the surface roughness Sq₁ of the first surface and a surface roughness Sq₂ of the second surface, Sq₁ + Sq₂, is 9.0 nm or more.

## Description

### Technical Field

The present disclosure relates to a method for producing a photosensitive element, a photosensitive element, a method for forming a resist pattern, and a method for producing a printed wiring board.

### Background Art

Conventionally, in the field of producing printed wiring boards, a photosensitive element including, as resist materials used for etching process, plating process, or the like, a photosensitive resin composition and a layer (hereinafter, also referred to as a "photosensitive layer") formed on a support film by using the photosensitive resin composition is widely used.

The printed wiring board is produced by, for example, the following procedure using the above-described photosensitive element. That is, first, the photosensitive layer of the photosensitive element is laminated on a circuit-forming substrate such as a copper-clad laminate. In this case, a surface of the photosensitive layer opposite to a surface in contact with the support film is laminated so as to be in close contact with a surface of the circuit-forming substrate on which a circuit is formed. In addition, the lamination is performed by, for example, thermocompression-bonding the photosensitive layer on the circuit-forming substrate (atmospheric pressure lamination method).

Next, a desired region of the photosensitive layer is exposed through the support film using a mask film or the like to generate radicals. The generated radicals pass through some reaction paths and contribute to a crosslinking reaction (photocuring reaction) of a photopolymerizable compound. Then, after the support film is peeled off, an uncured portion of the photosensitive layer is dissolved or dispersed and removed with a developer to form a resist pattern. Next, an etching process or a plating process is performed by using the resist pattern as a resist, to form a conductor pattern, and finally, a photocured portion (resist pattern) of the photosensitive layer is peeled off (removed).

Meanwhile, in recent years, while the density of semiconductor package substrates and printed wiring boards has increased, the demand for photosensitive elements with excellent resolution (resolution properties) and adhesion is increasing. In particular, there is a demand for a photosensitive element capable of forming a resist pattern having a line width/space width of 10/10 (unit: µm) or less in the production of a package substrate. For example, the resolution properties and adhesion improved by using a specific photopolymerizable compound is studied in Patent Literature 1.

### Citation List

### Patent Literature

Patent Literature 1: Japanese Unexamined Patent Publication No. 2013-195712

### Summary of Invention

### Technical Problem

However, the present inventors have found that in a case where a fine resist pattern having a line width/space width of 10/10 (unit: µm) or less is formed, and the smoothness of the sidewall of the resist pattern is low, a problem that the wiring is short-circuited and the yield is deteriorated occurs.

In order to solve the above-described problem, the present inventors have focused on a support film through which light passes during exposure of the photosensitive layer, and studied the influence on the smoothness of the sidewall of the resist pattern using various support films. However, the present inventors have found that, while the smoothness of the sidewall of the resist pattern can be improved depending on the support film used, the support film may be easily scratched during production of the photosensitive element, leading to a new problem of defects in the resist pattern.

The present disclosure has been made in view of the problems of the related art, and an object of the present disclosure is to provide a method for producing a photosensitive element capable of obtaining a photosensitive element, in which smoothness of a sidewall of a resist pattern is capable of being improved and the occurrence of scratches on a support film is minimized, a photosensitive element, a method for forming a resist pattern, and a method for producing a printed wiring board.

### Solution to Problem

In order to achieve the above-described object, the present disclosure provides a method for producing a photosensitive element, a photosensitive element, a method for forming a resist pattern, and a method for producing a printed wiring board described below.
[1] A method for producing a photosensitive element including a step of forming a photosensitive layer on a support film by using a photosensitive resin composition, in which in a case where a surface of the support film opposite to a surface of the support film on which the photosensitive layer is formed is defined as a first surface, and the surface of the support film on which the photosensitive layer is formed is defined as a second surface, a surface roughness Sq₁ of the first surface is 4.0 nm or less, and a total value of the surface roughness Sq₁ of the first surface and a surface roughness Sq₂ of the second surface, Sq₁ + Sq₂, is 9.0 nm or more.
[2] The method for producing a photosensitive element according to [1], in which Sq₁ + Sq₂ is 12.0 nm or less.
[3] The method for producing a photosensitive element according to [1] or [2], in which Sq₂ - Sq₁ is 1.0 nm or more.
[4] A photosensitive element including a support film, and a photosensitive layer, in which in a case where a surface of the support film opposite to a surface of the support film on which the photosensitive layer is formed is defined as a first surface, and the surface of the support film on which the photosensitive layer is formed is defined as a second surface, a surface roughness Sq₁ of the first surface is 4.0 nm or less, and a total value of the surface roughness Sq₁ of the first surface and a surface roughness Sq₂ of the second surface, Sq₁ + Sq₂, is 9.0 nm or more.
[5] The photosensitive element according to [4], in which Sq₁ + Sq₂ is 12.0 nm or less.
[6] The photosensitive element according to [4] or [5], in which Sq₂ - Sq₁ is 1.0 nm or more.
[7] The photosensitive element according to any one of [4] to [6], in which in a case where the support film of the photosensitive element is irradiated with light, and a smaller area of an entire area of the support film and a 2 m² area of the support film is observed, no recessed portion or crack having a maximum length of 50 µm or more is observed on both the first surface and the second surface of the support film.
[8] A method for forming a resist pattern, the method including a step of arranging a photosensitive layer and a support film on a substrate in this order from the substrate, using the photosensitive element according to any one of [4] to [7]; a step of exposing the photosensitive layer to an active ray through the support film; and a step of removing the support film and thereafter removing an uncured portion of the photosensitive layer from the substrate.
[9] A method for producing a printed wiring board, the method including a step of performing an etching process or a plating process on a substrate on which a resist pattern is formed by the method for forming a resist pattern according to claim 8 to form a conductor pattern.

### Advantageous Effects of Invention

According to the present disclosure, it is possible to provide the method for producing a photosensitive element capable of obtaining the photosensitive element, in which the smoothness of the sidewall of the resist pattern is capable of being improved and the occurrence of scratches on the support film is minimized, the photosensitive element, the method for forming a resist pattern, and the method for producing a printed wiring board.

### Brief Description of Drawings

FIG. 1 is a schematic cross-sectional view illustrating an embodiment of a photosensitive element of the present disclosure.
FIG. 2 is a view schematically illustrating an example of steps for producing a printed wiring board by a semi-additive process.

### Description of Embodiments

Hereinafter, preferred embodiments of the present disclosure will be described in detail with reference to the drawings as necessary. In the following embodiments, needless to say, the components (including element steps and the like) are not necessarily required unless otherwise specified or considered to be obviously required in principle. This also applies to numerical values and ranges, and it is intended to be construed that the present disclosure is not unduly limited.

Note that, in the present specification, "(meth)acrylic acid" means at least one of acrylic acid or methacrylic acid corresponding thereto. In addition, the same applies to other similar expressions such as (meth)acrylate. The materials exemplified below may be used alone or in combination of two or more unless otherwise specified. In a case where a plurality of substances corresponding to each component are present in a composition, the content of each component in the composition means the total amount of the plurality of substances present in the composition unless otherwise specified.

In addition, a "solid content" in the present specification refers to a non-volatile content excluding a volatile substance such as water or an organic solvent. That is, the solid content refers to a component other than a solvent, such as water or an organic solvent, which remains without being volatilized in a drying step, and also includes a liquid, a syrup, and a wax at room temperature around 25°C.

In the present specification, the term "step" includes not only an independent step but also a step that cannot be clearly distinguished from other steps as long as an intended action of the step is achieved.

Furthermore, in the present specification, a numerical range indicated using "to" indicates a range including numerical values described before and after "to" as a minimum value and a maximum value, respectively. In addition, with regard to numerical ranges described in stages in the present specification, an upper limit or a lower limit of a numerical range in a certain stage may be replaced with an upper limit or a lower limit of a numerical range in another stage. In addition, in the numerical range described in the present specification, the upper limit value or the lower limit value of the numerical range may be replaced with a value illustrated in the examples. In addition, in the present specification, the term "layer" includes a structure having a shape partially formed in addition to a structure having a shape formed on the entire surface when observed as a plan view.

### [Photosensitive Element and Method for Producing The Same]

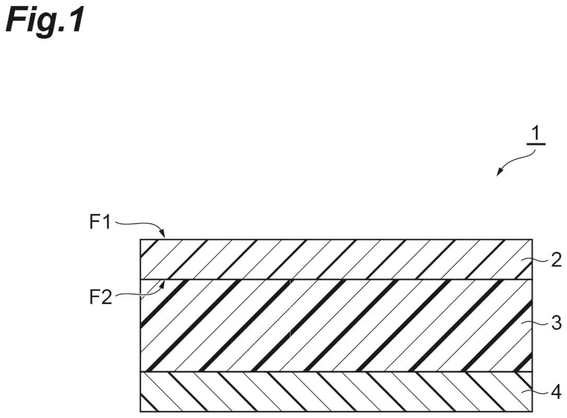

A method for producing a photosensitive element of the present embodiment includes a step of forming a photosensitive layer on a support film by using a photosensitive resin composition, in which in a case where a surface of the support film opposite to a surface of the support film on which the photosensitive layer is formed is defined as a first surface, and the surface of the support film on which the photosensitive layer is formed is defined as a second surface, a surface roughness Sq₁ of the first surface is 4.0 nm or less, and a total value of the surface roughness Sq₁ of the first surface and a surface roughness Sq₂ of the second surface, Sq₁ + Sq₂, is 9.0 nm or more. In addition, as illustrated in FIG. 1, a photosensitive element 1 of the present embodiment produced by the above-described production method may include a support film 2 and a photosensitive layer 3 in this order, and may further include another layer such as a protective layer 4. In addition, in a case where a surface of the support film 2 opposite to the photosensitive layer 3 is defined as a first surface F1, and a surface of the support film on which the photosensitive layer 3 is formed is defined as a second surface F2, a surface roughness Sq₁ of the first surface F1 is 4.0 nm or less, and a total value of the surface roughness Sq₁ of the first surface F1 and a surface roughness Sq₂ of the second surface F2, Sq₁ + Sq₂, is 9.0 nm or more. Hereinafter, each layer in the photosensitive element and the method for producing the photosensitive element according to the present embodiment will be described in detail.

### <Support Film>

Examples of the support film of the present embodiment include polyester films such as polyethylene terephthalate (PET), polybutylene terephthalate (PBT), and polyethylene-2,6-naphthalate (PEN), and polyolefin films such as polypropylene and polyethylene. Among these, a polyester film may be used. Since the polyester film is used as the support film, the mechanical strength and resistance to heat of the support film tend to be improved. In addition, a polyester film containing particles (lubricant or the like) may be used from the viewpoint of enhancing slip properties and winding properties. In a case where a polyester film containing particles (lubricant or the like) is used, the photosensitive layer may be formed on a surface containing the particles (lubricant or the like). As such a polyester film, for example, a polyester film in which particles (lubricant or the like) are kneaded, a polyester film in which either both surfaces contain particles (lubricant or the like), or a polyester film in which only one surface contains particles (lubricant or the like) may be used. Among these, it is preferable to use a polyester film containing particles (lubricant or the like) only on the surface on which the photosensitive layer is formed (second surface F2 side) because Sq₁ and Sq₂ easily satisfy the above-described conditions. Note that the support film may be a single layer or a multilayer.

Examples of a method for adding particles such as a lubricant to the support film include a method for kneading particles (lubricant or the like) into the support film, and a method for forming a layer containing particles (lubricant or the like) on the support film by using a known method such as roll coating, flow coating, spray coating, curtain flow coating, dip coating, or slit die coating. In a case where the support film contains particles such as a lubricant, a particle diameter thereof may be, for example, 0.1 to 2.0 µm.

In the support film, the surface roughness Sq₁ of the first surface F1 is 4.0 nm or less, and the total value of the surface roughness Sq₁ of the first surface F1 and the surface roughness Sq₂ of the second surface F2, Sq₁ + Sq₂, is 9.0 nm or more. In the case where Sq₁ is 4.0 nm or less, it is possible to inhibit refraction of exposed light due to the influence of the surface roughness Sq₁ of the first surface F1 when the photosensitive layer is exposed through the support film, and to improve smoothness of a sidewall of the resist pattern. In addition, in the case where Sq₁ + Sq₂ is 9.0 nm or more, it is possible to minimize the occurrence of scratches on the support film due to rubbing between the support films during the production of the photosensitive elements.

The surface roughness Sq means a root mean square height. The surface roughnesses Sq₁ and Sq₂ of the support film can be measured by, for example, a scanning white-light interference microscope.

Sq₁ is 4.0 nm or less, and may be 3.8 nm or less or 3.7 nm or less from the viewpoint of further improving the smoothness of the sidewall of the resist pattern. On the other hand, Sq₁ may be 2.5 nm or more or 3.0 nm or more from the viewpoint of further minimizing the occurrence of scratches on the support film during the production of the photosensitive element.

Sq₂ is not particularly limited, and may be 8.0 nm or less or 7.5 nm or less from the viewpoint of further improving the smoothness of the sidewall of the resist pattern. On the other hand, Sq₂ may be 1.0 nm or more or 1.5 nm or more from the viewpoint of improving resist sticking.

Sq₁ + Sq₂ is 9.0 nm or more, and may be 9.1 nm or more or 9.2 nm or more from the viewpoint of further minimizing the occurrence of scratches on the support film. On the other hand, the Sq₁ + Sq₂ may be 12.0 nm or less or 11.5 nm or less from the viewpoint of further improving the smoothness of the sidewall of the resist pattern.

The difference Sq₂ - Sq₁ between Sq₁ and Sq₂ is not particularly limited, and may be 1.0 nm or more, or 1.1 nm or more, and 3.0 nm or less, or 2.5 nm or less from the viewpoint of achieving both the smoothness of the sidewall of the resist pattern and the minimization of the occurrence of scratches on the support film in a well-balanced manner.

The haze of the support film may be 0.01% to 5.0%, 0.01% to 1.5%, 0.01% to 1.0%, or 0.01% to 0.5%. The haze of the support film may be less than 0.5%. In a case where the haze is 0.01% or more, the support film itself tends to be easily produced, and in a case where the haze is 5.0% or less, foreign matters in the photosensitive layer tend to be easily detected during the formation of the photosensitive layer of the photosensitive element. Here, the "haze" means the degree of haze. The haze in the present disclosure refers to a value measured by using a commercially available haze meter (turbidimeter) in accordance with a method specified in JIS K7105. The haze can be measured by, for example, a commercially available turbidimeter such as NDH-5000 (product name, manufactured by Nippon Denshoku Industries Co., Ltd.).

The thickness of the support film may be 1 to 200 µm, 1 to 100 µm, 1 to 60 µm, 5 to 60 µm, 10 to 60 µm, 10 to 50 µm, 10 to 40 µm, 10 to 30 µm, or 10 to 25 µm. In a case where the thickness of the support film is 1 µm or more, it is likely to ensure breakage of the support film to be minimized when the support film is peeled off. In addition, in a case where the thickness of the support film is 200 µm or less, it tends to result in an improvement in lamination properties of the resist and obtaining economic benefits.

In a state where the support film is included in the photosensitive element, in a case where the support film of the photosensitive element is irradiated with light, and a smaller area of the entire area of the support film and a 2 m² area of the support film is observed, no recessed portion or crack having a maximum length of 50 µm or more is observed on both the first surface and the second surface of the support film. Such conditions can be satisfied by producing the photosensitive element using the production method of the present embodiment. In addition, a resist pattern without defects can be formed by using the photosensitive element including the support film satisfying the above-described conditions.

### <Photosensitive Layer>

The photosensitive layer of the present embodiment includes a layer formed by using a photosensitive resin composition described later. The photosensitive resin composition can be used according to a desired purpose as long as the photosensitive resin composition changes in properties (for example, photocuring is performed) when irradiated with light, and may be a negative type or a positive type. The photosensitive resin composition may contain (A) a binder polymer, (B) a photopolymerizable compound, and (C) a photopolymerization initiator. In addition, the photosensitive resin composition may contain (D) a photosensitizer, a polymerization inhibitor, or other components as necessary. Hereinafter, each component used in the photosensitive resin composition of the present embodiment will be described in more detail.

### ((A) Binder Polymer)

(A) The binder polymer (hereinafter, also referred to as the "(A) component") can be produced by, for example, radically polymerizing a polymerizable monomer. Examples of the polymerizable monomer include polymerizable styrene derivatives substituted at an α-position or on an aromatic ring, such as styrene, vinyltoluene, and α-methylstyrene, acrylic amides such as diacetone acrylamide, acrylonitrile, vinyl alcohol ethers such as vinyl-n-butyl ether, (meth)acrylic acid alkyl ester, (meth)acrylic acid benzyl esters such as benzyl methacrylate, (meth)acrylic acid tetrahydrofurfuryl ester, (meth)acrylic acid dimethylaminoethyl ester, (meth)acrylic acid diethylaminoethyl ester, (meth)acrylic acid glycidyl ester, 2,2,2-trifluoroethyl (meth)acrylate, 2,2,3,3-tetrafluoropropyl (meth)acrylate, (meth)acrylic acid, α-bromoacrylic acid, α-chloroacrylic acid, β-furyl (meth)acrylic acid, β-styryl (meth)acrylic acid, maleic acid, maleic anhydride, maleic acid monoesters such as monomethyl maleate, monoethyl maleate, and monoisopropyl maleate, fumaric acid, cinnamic acid, α-cyanocinnamic acid, itaconic acid, crotonic acid, and propiolic acid. These can be used singly or in combination of two or more kinds thereof.

Among these, the (meth)acrylic acid alkyl ester may be contained from the viewpoint of improving plasticity. Examples of the (meth)acrylic acid alkyl ester include compounds represented by General Formula (I) described below and compounds in which an alkyl groups of these compounds is substituted with a hydroxyl group, an epoxy group, a halogen group, or the like.

H₂C = C(R⁶) - COOR⁷ (I)

In Formula (I), R⁶ represents a hydrogen atom or a methyl group, and R⁷ represents an alkyl group having 1 to 12 carbon atoms. Examples of the alkyl group having 1 to 12 carbon atoms, represented by R⁷, include a methyl group, an ethyl group, a propyl group, a butyl group, a pentyl group, a hexyl group, a heptyl group, an octyl group, a nonyl group, a decyl group, an undecyl group, a dodecyl group, and structural isomers of these groups.

Examples of the (meth)acrylic acid alkyl ester represented by Formula (I) described above include (meth)acrylic acid methyl ester, (meth)acrylic acid ethyl ester, (meth)acrylic acid propyl ester, (meth)acrylic acid butyl ester, (meth)acrylic acid pentyl ester, (meth)acrylic acid hexyl ester, (meth)acrylic acid heptyl ester, (meth)acrylic acid octyl ester, (meth)acrylic acid 2-ethylhexyl ester, (meth)acrylic acid nonyl ester, (meth)acrylic acid decyl ester, (meth)acrylic acid undecyl ester, and (meth)acrylic acid dodecyl ester. These can be used singly or in combination of two or more kinds thereof.

In addition, the (A) component may contain a carboxy group from the viewpoint of alkali developability. The (A) component containing a carboxy group can be produced by, for example, radically polymerizing a polymerizable monomer having a carboxy group with another polymerizable monomer. The polymerizable monomer having a carboxy group may be (meth)acrylic acid or methacrylic acid. In addition, the acid value of the (A) component containing a carboxy group may be 50 to 250 mgKOH/g, 50 to 200 mgKOH/g, or 100 to 200 mgKOH/g.

The carboxy group content (the formulation ratio of the polymerizable monomer having a carboxy group to the total amount of the polymerizable monomers used in a binder polymer) of the (A) component may be 12% to 50% by mass, 12% to 40% by mass, 15% to 35% by mass, 15% to 30% by mass, or 20% to 30% by mass from the viewpoint of improving the alkali developability and the alkali resistance in a well-balanced manner. In a case where the carboxy group content is 12% by mass or more, the alkali developability tends to be improved, and in a case where the carboxy group content is 50% by mass or less, the alkali resistance tends to be excellent.

Since the content of a structural unit derived from the polymerizable monomer having a carboxy group in the (A) component correlates with the formulation ratio of the polymerizable monomer having a carboxy group, the content may be 12% to 50% by mass, 12% to 40% by mass, 15% to 35% by mass, 15% to 30% by mass, or 20% to 30% by mass.

As the (A) component, styrene or a styrene derivative may also be used as a polymerizable monomer from the viewpoint of adhesion and chemical resistance. In a case where the styrene or styrene derivative is used as the polymerizable monomer, the content thereof (the formulation ratio of the styrene or styrene derivative to the total amount of the polymerizable monomers used in the (A) component) may be 10% to 60% by mass, 15% to 50% by mass, 30% to 50% by mass, 35% to 50% by mass, or 40% to 50% by mass from the viewpoint of further improving adhesion and chemical resistance. In a case where the content is 10% by mass or more, adhesion tends to be improved, and in a case where the content is 60% by mass or less, it is possible to minimize an increase in a peeled piece during development, and it tends to reduce the lengthening of time required for peeling.

Furthermore, since the content of the structural unit derived from styrene or a styrene derivative in the (A) component correlates with the formulation ratio of the styrene or styrene derivative, the content may be 10% to 60% by mass, 15% to 50% by mass, 30% to 50% by mass, 35% to 50% by mass, or 40% to 50% by mass.

As the (A) component, (meth)acrylic acid benzyl ester may also be used as a polymerizable monomer from the viewpoint of resolution and an aspect ratio. The content of the structural unit derived from (meth)acrylic acid benzyl ester in the (A) component may be 15% to 50% by mass, 15% to 45% by mass, 15% to 40% by mass, 15% to 35% by mass, or 20% to 30% by mass from the viewpoint of further improving resolution and an aspect ratio.

These binder polymers can be used singly or in combination of two or more kinds thereof. Examples of the (A) component used in combination of two or more kinds thereof include two or more binder polymers containing different polymerizable monomers, two or more binder polymers having different weight-average molecular weights, and two or more binder polymers having different dispersion degrees.

The (A) component can be produced according to known methods. Specifically, for example, the (A) component can be produced by radically polymerizing (meth)acrylic acid alkyl ester, (meth)acrylic acid, styrene, and the like.

The weight-average molecular weight of the (A) component may be 20,000 to 300,000, 40,000 to 150,000, 40,000 to 120,000, or 50,000 to 80,000 from the viewpoint of improving the mechanical strength and the alkali developability in a well-balanced manner. In a case where the weight-average molecular weight of the (A) component is 20,000 or more, developer resistance tends to be excellent, and in a case where the weight-average molecular weight of the (A) component is 300,000 or less, it tends to reduce the lengthening of time required for development. Note that the weight-average molecular weight in the present specification is measured by a gel permeation chromatography (GPC) method and is a value converted based on a calibration curve created using standard polystyrene.

The content of the (A) component may be 30 to 80 parts by mass, 40 to 75 parts by mass, 50 to 70 parts by mass, or 50 to 60 parts by mass with respect to 100 parts by mass of the total solid content of the (A) component and a (B) component described later. In a case where the content of the (A) component is within this range, the coating properties of the photosensitive resin composition and the strength of the photocured portion are further improved.

### ((B) Photopolymerizable Compound)

The photosensitive resin composition according to the present embodiment may contain (B) a photopolymerizable compound (hereinafter, also referred to as the "(B) component"). The (B) component is not particularly limited as long as it is a photopolymerizable compound or a photocrosslinkable compound, and for example, a compound having at least one ethylenically unsaturated bond in the molecule can be used.

As the (B) component, a bisphenol type (meth)acrylate compound may be contained. Examples of the bisphenol type (meth)acrylate compound include 2,2-bis(4-((meth)acryloxypolyethoxy)phenyl)propane, 2,2-bis(4-((meth)acryloxypolypropoxy)phenyl)propane, and 2,2-bis(4-((meth)acryloxypolyethoxypolypropoxy)phenyl)propane. These can be used singly or in combination of two or more kinds thereof. In addition, as the bisphenol type (meth)acrylate compound, 2,2-bis(4-(methacryloxypentaethoxy)phenyl)propane and 2,2-bis(4-(methacryloxydiethoxy)phenyl)propane may be contained.

Examples of commercially available bisphenol type (meth)acrylate compounds include 2,2-bis(4-(methacryloxydiethoxy) phenyl)propane ("BPE-200" manufactured by SHIN-NAKAMURA CHEMICAL Co., Ltd.), 2,2-bis(4-(methacryloxypentaethoxy) phenyl)propane ("BPE-500" manufactured by SHIN-NAKAMURA CHEMICAL Co., Ltd., or "FA-321 M" manufactured by Resonac Corporation), 2,2-bis(4-(methacryloxypentadecaethoxy)phenyl)propane ("BPE-1300" manufactured by SHIN-NAKAMURA CHEMICAL Co., Ltd.), and 2,2-bis(4-(methacryloxypolyethoxy)phenyl)propane ("BP-2EM" (EO group: 2.6 (average value)) manufactured by Kyoeisha Chemical Co., Ltd.).

The content of the bisphenol type (meth)acrylate compound may be 1% to 50% by mass, 3% to 40% by mass, 10% to 40% by mass, 20% to 40% by mass, or 30% to 40% by mass with respect to the total solid content of the (A) component and the (B) component from the viewpoint of further improving the chemical resistance.

In addition, the content of the bisphenol type (meth)acrylate compound may be 30% to 99% by mass, 50% to 97% by mass, 60% to 95% by mass, 70% to 95% by mass, or 80% to 90% by mass with respect to the total solid content of the (B) component from the viewpoint of further improving the chemical resistance.

The content of the (B) component may be 20 to 70 parts by mass, 25 to 60 parts by mass, or 30 to 50 parts by mass, with respect to 100 parts by mass of the total solid content of the (A) component and the (B) component. In a case where the content of the (B) component is within this range, the photosensitivity and the coating properties of the photosensitive resin composition are further improved in addition to the improvement in the resolution, adhesion, and the reduction in the occurrence of resist foot defects.

### ((C) Photopolymerization Initiator)

The photosensitive resin composition according to the present embodiment may contain at least one photopolymerization initiator (C) (hereinafter, also referred to as the "(C) component"). The (C) component is not particularly limited as long as it can polymerize the (B) component, and can be appropriately selected from commonly used photopolymerization initiators.

Examples of the (C) component include: aromatic ketones such as 2-benzyl-2-dimethylamino-1-(4-morpholinophenyl)-butanone-1 and 2-methyl-1-[4-(methylthio)phenyl-2-morpholino-propanone-1; quinones such as alkyl anthraquinones; benzoin ether compounds such as benzoin alkyl ethers; benzoin compounds such as benzoin and alkyl benzoin; benzyl derivatives such as benzyl dimethyl ketal; 2,4,5-triaryl imidazole dimers such as 2-(o-chlorophenyl)-4,5-diphenyl imidazole dimers and 2-(o-fluorophenyl)-4,5-diphenyl imidazole dimers; and acridine derivatives such as 9-phenyl acridine and 1,7-(9,9'-acridinyl)heptane. These can be used singly or in combination of two or more kinds thereof.

Among these, a 2,4,5-triarylimidazole dimer may be contained from the viewpoint of improving the resolution. Examples of the 2,4,5-triarylimidazole dimer include a 2-(o-chlorophenyl)-4,5-diphenylimidazole dimer, a 2-(o-chlorophenyl)-4,5-bis-(m-methoxyphenyl)imidazole dimer, and a 2-(p-methoxyphenyl)-4,5-diphenylimidazole dimer. Among these, from the viewpoint of improving the photosensitivity stability, a 2-(o-chlorophenyl)-4,5-diphenylimidazole dimer may be contained.

As the 2,4,5-triarylimidazole dimer, for example, 2,2'-bis(2-chlorophenyl)-4,4',5,5'-tetraphenylbiimidazole is commercially available as B-CIM (product name, manufactured by Hodogaya Chemical Co., Ltd.).

The (C) component may contain at least one 2,4,5-triarylimidazole dimer or may contain a 2-(2-chlorophenyl)-4,5-diphenylimidazole dimer from the viewpoint of further improving the photosensitivity and the adhesion and further reducing the light absorption of the (C) component. The 2,4,5-triarylimidazole dimer may be symmetric or asymmetric in structure.

The content of the (C) component may be 0.01 to 30 parts by mass, 0.1 to 10 parts by mass, 1 to 7 parts by mass, 1 to 6 parts by mass, 1 to 5 parts by mass, or 2 to 5 parts by mass with respect to 100 parts by mass of the total solid content of the (A) component and the (B) component. In a case where the content of the (C) component is 0.01 parts by mass or more, the photosensitivity, resolution, and adhesion tend to be improved, and in a case where the content is 30 parts by mass or less, the resist pattern shape tends to be excellent.

### ((D) Photosensitizer)

The photosensitive resin composition according to the present embodiment may contain (D) a photosensitizer (hereinafter, also referred to as the "(D) component"). In a case where the (D) component contained, the absorption wavelength of an active ray used for exposure tends to be effectively utilized.

Examples of the (D) component include pyrazolines, dialkylaminobenzophenones, anthracenes, coumarins, acridines, xanthones, oxazoles, benzoxazoles, thiazoles, benzothiazoles, triazoles, stilbenes, triazines, thiophenes, naphthalimides, and triarylamines. These can be used singly or in combination of two or more kinds thereof. The (D) component may contain pyrazolines, anthracenes, coumarins, acridines, or dialkylaminobenzophenones, and among these, the (D) component may contain coumarins, acridines, or dialkylaminobenzophenones, or may contain dialkylaminobenzophenones from the viewpoint that the absorption wavelength of the active ray used for exposure can be more effectively utilized. Examples of commercially available dialkylaminobenzophenones include "EAB" manufactured by Hodogaya Chemical Co., Ltd.

In a case where the (D) component is contained, the content thereof may be 1.0 parts by mass or less, 0.5 parts by mass or less, 0.15 parts by mass or less, 0.12 parts by mass or less, or 0.10 parts by mass or less with respect to 100 parts by mass of the total solid content of the (A) component and the (B) component. In a case where the content of the (D) component is 1.0 parts by mass or less with respect to 100 parts by mass of the total solid content of the (A) component and the (B) component, deterioration of the resist pattern shape and the occurrence of resist foot defects can be minimized, and the resolution tends to be further improved. In addition, the content of the (D) component may be 0.01 parts by mass or more with respect to 100 parts by mass of the total solid content of the (A) component and the (B) component from the viewpoint of easily obtaining the high photosensitivity and the improved resolution.

### (Polymerization Inhibitor)

The photosensitive resin composition according to the present embodiment may contain a polymerization inhibitor. In a case where the photosensitive resin composition contains a polymerization inhibitor, the exposure amount required for photocuring the photosensitive resin composition tends to be adjusted to an exposure amount optimal for exposure with a projection exposure machine. Examples of the polymerization inhibitor include catechol, resorcinol (resorcin), 1,4-hydroquinone, alkylcatechols such as 2-methylcatechol, 3-methylcatechol, 4-methylcatechol, 2-ethylcatechol, 3-ethylcatechol, 4-ethylcatechol, 2-propylcatechol, 3-propylcatechol, 4-propylcatechol, 2-n-butylcatechol, 3-n-butylcatechol, 4-n-butylcatechol, 2-tert-butylcatechol, 3-tert-butylcatechol, 4-tert-butylcatechol, and 3,5-di-tert-butylcatechol; alkylresorcinols such as 2-methylresorcinol, 4-methylresorcinol, 5-methylresorcinol (orcinol), 2-ethylresorcinol, 4-ethylresorcinol, 2-propylresorcinol, 4-propylresorcinol, 2-n-butylresorcinol, 4-n-butylresorcinol, 2-tert-butylresorcinol, and 4-tert-butylresorcinol; alkylhydroquinones such as methylhydroquinone, ethylhydroquinone, propylhydroquinone, tert-butylhydroquinone, and 2,5-di-tert-butylhydroquinone; pyrogallol; and, phloroglucinol. These can be used singly or in combination of two or more kinds thereof.

### (Other Components)

The photosensitive resin composition according to the present embodiment may contain, as necessary, additives such as, for example, dyes such as malachite green, Victoria Pure Blue, Brilliant Green and methyl violet, photochromic agents such as tribromophenylsulfone, leucocrystal violet, diphenylamine, benzylamine, triphenylamine, diethylaniline, and o-chloroaniline, heat generation inhibitors, plasticizers such as p-toluenesulfonamide, pigments, fillers, defoamers, flame retardants, adhesion imparting agents, leveling agents, peeling accelerators, antioxidants, fragrances, imaging agents and thermal crosslinking agents, each in an amount of 0.01 to 20 parts by mass relative to 100 parts by mass of the total solid content of the (A) component and the (B) component. These additives can be used singly or in combination of two or more kinds thereof.

In addition, the photosensitive resin composition according to the present embodiment can contain at least one organic solvent as necessary in order to improve the handleability of the photosensitive composition and to adjust the viscosity and storage stability. As the organic solvent, it is possible to use an organic solvent usually used without particular limitation. Specific examples thereof include organic solvents such as methanol, ethanol, acetone, methyl ethyl ketone, methyl cellosolve, ethyl cellosolve, toluene, N, N-dimethylformamide, propylene glycol and monomethyl ether, and mixed solvents thereof. These can be used singly or in combination of two or more kinds thereof.

### <Protective Layer>

In the photosensitive element of the present embodiment, a protective layer can be laminated on the surface of the photosensitive layer opposite to the surface in contact with the support film. As the protective layer, for example, a polymer film of polyethylene, polypropylene, or the like may be used. In addition, a polymer film similar to the above-described support film may be used, or a different polymer film may be used.

Hereinafter, a method for producing a photosensitive element in which a support film, a photosensitive layer, and a protective layer are sequentially laminated will be described.

### <Method for Producing Photosensitive Element>

The photosensitive element can be produced by applying the photosensitive resin composition on the second surface F2 of the support film, drying the photosensitive resin composition to form the photosensitive layer, and laminating the protective layer on the photosensitive layer.

The photosensitive resin composition can be applied onto the support film by a known method such as roll coating, comma coating, gravure coating, air knife coating, die coating, bar coating, or spray coating.

The drying of the applied photosensitive resin composition is not particularly limited as long as at least a part of a solvent such as water can be removed, and the photosensitive resin composition may be dried at 70°C to 150°C for 5 to 30 minutes. After drying, the amount of the remaining solvent in the photosensitive layer may be 2% by mass or less from the viewpoint of preventing diffusion of the solvent in the subsequent step.

The thickness of the photosensitive layer in the photosensitive element can be appropriately selected depending on the application, and may be 1 µm or more, 5 µm or more, or 10 µm or more, and may be 200 µm or less, 100 µm or less, 50 µm or less, or less than 20 µm in the thickness after drying. In a case where the thickness of the photosensitive layer is 1 µm or more, 5 µm or more, or 10 µm or more, industrial coating is facilitated, and productivity tends to be improved. In addition, in a case where the thickness of the photosensitive layer is 200 µm or less, 100 µm or less, 50 µm or less, or less than 20 µm, there is a tendency that a resist pattern excellent in resolution and an aspect ratio can be formed because the photosensitive layer has a high photosensitivity and excellent photocurability at the bottom of the resist.

The melt viscosity of the photosensitive layer in the photosensitive element at 110°C can be appropriately selected depending on the type of a base material (underlayer) in contact with the photosensitive layer, and may be 50 to 10000 Pa·s, 100 to 5000 Pa·s, or 200 to 1000 Pa·s at 110°C after drying. In a case where the melt viscosity at 110°C is 50 Pa·s or more, wrinkles and voids are not generated in the laminating step, and productivity tends to be improved. In addition, in a case where the melt viscosity at 110°C is 10000 Pa·s or less, adhesiveness with the underlayer is improved in the laminating step, and adhesive failure tends to be reduced.

The form of the photosensitive element according to the present embodiment is not particularly limited. For example, the photosensitive element may have a sheet shape or a shape wound around a winding core in a roll shape. In a case where the photosensitive element is wound in the roll shape, the photosensitive element may be wound so that the support film is positioned on the outer side. Examples of the material of the winding core include plastics such as polyethylene resins, polypropylene resins, polystyrene resins, polyvinyl chloride resins, and acrylonitrile-butadiene-styrene copolymer (ABS) resins.

An end surface separator may be installed on an end surface of a photosensitive element roll with a roll shape thus obtained from the viewpoint of end surface protection, or a moisture-proof end surface separator may be installed from the viewpoint of edge fusion resistance. As a packaging method, the packaging may be performed with a black sheet having low moisture permeability.

The photosensitive element according to the present embodiment can be suitably used in, for example, a method for forming a resist pattern and a method for producing a printed wiring board described later.

### [Method for Forming Resist Pattern]

A method for forming a resist pattern according to the present embodiment includes (i) a step of arranging a photosensitive layer and a support film on a substrate in this order from the substrate, using the photosensitive element (hereinafter, also referred to as the "(i) photosensitive layer-forming step"), (ii) a step of exposing the photosensitive layer to an active ray through the support film (hereinafter, also referred to as the "(ii) exposure step"), and (iii) a step of removing the support film and removing an uncured portion of the photosensitive layer from the substrate (hereinafter, also referred to as the "(iii) developing step"), and may include other steps as necessary. Note that the resist pattern can be said to be a photocured product pattern of a photosensitive resin composition or can also be said to be a relief pattern. In addition, according to the purpose, the resist pattern in the present embodiment may be used as a resist or may be used for other purposes such as a protective film.

### ((i) Photosensitive Layer-Forming Step)

In the photosensitive layer-forming step, the photosensitive layer is formed on the substrate using the photosensitive element. The substrate is not particularly limited, and a circuit-forming substrate including an insulating layer and a conductor layer formed on the insulating layer, a die pad (base material for a leadframe) such as an alloy base material, or the like is usually used.

As a method for forming the photosensitive layer on the substrate, for example, in a case where the photosensitive element having the protective layer is used, the photosensitive layer can be formed on the substrate by removing the protective layer and then compression-bonding the photosensitive layer of the photosensitive element to the substrate while heating the photosensitive layer. As a result, a laminated body including the substrate, the photosensitive layer, and the support film in this order is obtained.

In a case where the photosensitive layer-forming step is carried out using the photosensitive element, the photosensitive layer-forming step may be performed under reduced pressure from the viewpoint of adhesion and followability. Heating during the compression-bonding may be performed at a temperature of 70°C to 130°C, and the compression-bonding may be performed at a pressure of 0.1 to 1.0 MPa (1 to 10 kgf/cm²), but these conditions can be appropriately selected as necessary. In a case where the photosensitive layer of the photosensitive element is heated to 70°C to 130°C, it is not necessary to preheat the substrate in advance, but the substrate can be preheated in order to further improve adhesion and followability.

### ((ii) Exposure Step)

In the exposure step, the photosensitive layer is exposed to an active ray through the support film. As a result, the exposed portion irradiated with the active ray may be photocured to form a photocured portion (latent image), and an unexposed portion that is a portion not irradiated with the active ray may be photocured to form a photocured portion. In a case where the photosensitive layer is exposed in a state where the support film is peeled off, the presence of oxygen tends to inhibit curing of the photosensitive layer, resulting in a difficulty of the formation of a normal resist pattern, while exposing the photosensitive layer through the support film enables the minimization of oxygen inhibition as described above, thereby allowing the formation of a normal resist pattern.

As the exposure method, a known exposure method can be applied, and examples thereof include, for example, a method of irradiating an image with an active ray through a negative or positive mask pattern called an artwork (mask exposure method), an LDI (laser direct imaging) exposure method, a method of irradiating an image through a lens using an active ray in which an image of a photomask is projected (projection exposure method), or the like. Among these, a projection exposure method may be used from the viewpoint of excellent resolution. That is, the photosensitive element according to the present embodiment may be applied to a projection exposure method. Note that the projection exposure method can also be said to be an exposure method using an active ray having an attenuated energy amount.

A light source of the active ray is not particularly limited as long as it is a commonly used known light source, and for example, a light source that effectively emits ultraviolet rays, such as a gas laser such as a carbon arc lamp, a mercury vapor arc lamp, an ultra-high pressure mercury lamp, a high pressure mercury lamp, a xenon lamp, or an argon laser; a solid laser such as a YAG laser; or a semiconductor laser such as a gallium nitride-based blue-violet laser is used. In addition, a light source that effectively emits visible light, such as a photographic floodlight bulb or a solar lamp, may be used. Among these, from the viewpoint of improving the resolution and the alignment properties in a well-balanced manner, a light source capable of emitting i-line monochromatic light with an exposure wavelength of 365 nm, a light source capable of emitting h-line monochromatic light with an exposure wavelength of 405 nm, or a light source capable of emitting active rays with an exposure wavelength of ihg mixed rays may be used, and among these, a light source capable of emitting i-line monochromatic light with an exposure wavelength of 365 nm may be used. Examples of the light source capable of emitting i-ray monochromatic light with an exposure wavelength of 365 nm include an ultra-high pressure mercury lamp.

### ((iii) Developing Step)

In the developing step, the support film is peeled off and removed from the photosensitive layer, and then an uncured portion of the photosensitive layer is removed from the substrate. A resist pattern including the photocured portion in which the photosensitive layer is photocured is formed on the substrate by the developing step. Examples of the developing method include wet development.

In a case of wet development, development can be performed by a known wet development method using a developer corresponding to the photosensitive resin composition. Examples of the wet development method include methods using a dipping method, a paddle method, a high-pressure spraying method, brushing, slapping, scrubbing, rocking immersion, and the like, and the high-pressure spraying method is most suitable from the viewpoint of improving the resolution. The development may be performed by using these wet development methods singly or in combination of two or more methods thereof.

The developer is appropriately selected according to the configuration of the photosensitive resin composition. Examples thereof include an alkaline aqueous solution and an organic solvent developer.

From the viewpoint of safety, stability, and good operability, an alkaline aqueous solution may be used as the developer. As the base of the alkaline aqueous solution, for example, alkali hydroxide such as hydroxide of lithium, sodium, or potassium; alkaline carbonate such as carbonate or bicarbonate of lithium, sodium, potassium, or ammonium; alkali metal phosphate such as potassium phosphate or sodium phosphate; alkali metal pyrophosphate such as sodium pyrophosphate or potassium pyrophosphate; sodium borate; sodium metasilicate; tetramethylammonium hydroxide; ethanolamine; ethylenediamine; diethylenetriamine; 2-amino-2-hydroxymethyl-1,3-propanediol; 1,3-diamino-2-propanol; and morpholine are used.

As the alkaline aqueous solution used for development, for example, a dilute solution containing 0.1% to 5% by mass sodium carbonate, a dilute solution containing 0.1% to 5% by mass potassium carbonate, a dilute solution containing 0.1% to 5% by mass sodium hydroxide, a dilute solution containing 0.1% to 5% by mass sodium tetraborate, or the like can be used. In addition, the pH of the alkaline aqueous solution used for the development may be within a range of 9 to 11, and the temperature of the alkaline aqueous solution can be adjusted in accordance with the developability of the photosensitive layer. In addition, for example, a surface active agent, an antifoaming agent, a small amount of an organic solvent for promoting development, and the like may be mixed into the alkaline aqueous solution. Examples of the organic solvent used for the alkaline aqueous solution include 3-acetone alcohol, acetone, ethyl acetate, alkoxyethanol having an alkoxy group having 1 to 4 carbon atoms, ethyl alcohol, isopropyl alcohol, butyl alcohol, diethylene glycol monomethyl ether, diethylene glycol monoethyl ether, and diethylene glycol monobutyl ether.

Examples of the organic solvent used in the organic solvent developer include 1,1,1-trichloroethane, N-methylpyrrolidone, N,N-dimethylformamide, cyclohexanone, methyl isobutyl ketone, and γ-butyrolactone. From the viewpoint of preventing ignition, water may be added to the organic solvent within a range of 1% to 20% by mass to form an organic solvent developer.

### (Other Steps)

The method for forming a resist pattern according to the present embodiment may include a step of further curing the resist pattern by removing the uncured portion in the development step and then, as necessary performing heating at 60°C to 250°C or exposure at an exposure amount of 0.2 to 10 J/cm².

### [Method for Producing Printed Wiring Board]

A method for producing a printed wiring board according to the present embodiment includes a step of performing an etching process or a plating process on a substrate on which a resist pattern is formed by the method for forming a resist pattern to form a conductor pattern, and as necessary, may include other steps such as a resist pattern removing step. The method for producing a printed wiring board according to the present embodiment can be suitably used for forming a conductor pattern by the method for forming a resist pattern using the photosensitive element described above, and in particular, the application to a method for forming a conductor pattern by the plating process is more suitable. Note that the conductor pattern can also be referred to as a circuit.

In the etching process, the conductor layer of the substrate not covered with the resist is removed by etching using the resist pattern formed on the substrate including the conductor layer as a mask to form a conductor pattern.

The method for the etching process is appropriately selected according to the conductor layer to be removed. Examples of an etching solution include a cupric chloride solution, a ferric chloride solution, an alkaline etching solution, and a hydrogen peroxide-based etching solution, and a ferric chloride solution may be used from the viewpoint of a favorable etch factor.

On the other hand, in the plating process, copper, solder, or the like is plated on the conductor layer of the substrate not covered with the resist using the resist pattern formed on the substrate including the conductor layer as a mask. After the plating process, the resist is removed by removing a resist pattern described later, and the conductor layer covered with this resist is subjected to etching to form a conductor pattern.

Methods of the plating process may be an electrolytic plating process or an electroless plating process, and may be an electroless plating process among them. Examples of the electroless plating process include copper plating such as copper sulfate plating and copper pyrophosphate plating; solder plating such as high-slow solder plating; Watt bath (nickel sulfate-nickel chloride) plating; nickel plating such as nickel sulfamate plating; and gold plating such as hard gold plating and soft gold plating.

After the etching process or the plating process, the resist pattern on the substrate is removed. The resist pattern can be peeled off and removed by, for example, a more strongly alkaline aqueous solution than the alkaline aqueous solution used in the development step. As the strongly alkaline aqueous solution, for example, a 1% to 10% by mass aqueous sodium hydroxide solution, a 1% to 10% by mass aqueous potassium hydroxide solution, or the like is used. Among these, a 1% to 5% by mass aqueous sodium hydroxide solution or aqueous potassium hydroxide solution may be used.

Examples of the method for removing a resist pattern include an immersion method and a spraying method, and these methods may be used alone or in combination thereof.

In a case where the resist pattern is removed after the plating process is performed, a desired printed wiring board can be produced by further etching the conductor layer covered with the resist by the etching process to form a conductor pattern. In this case, the method for the etching process is appropriately selected according to the conductor layer to be removed. For example, the etching solution described above can be applied.

The method for producing a printed wiring board according to the present embodiment can be applied not only to a single-layer printed wiring board, but also to a multilayer printed wiring board, and can also be applied to a printed wiring board having a small-diameter through hole or the like.

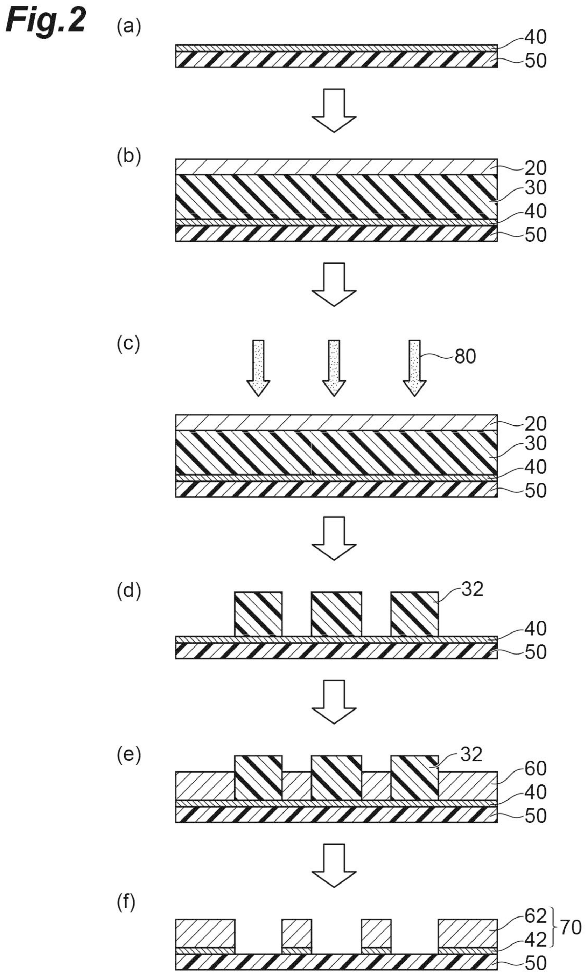

The method for producing a printed wiring board according to the present embodiment can be suitably used for producing a high-density package substrate, particularly for producing a wiring board by a semi-additive process. FIG. 2 illustrates an example of steps for producing a printed wiring board by a semi-additive process.

In FIG. 2(a), a substrate (circuit-forming substrate) in which a conductor layer 40 is formed on an insulating layer 50 is prepared. The conductor layer 40 is, for example, a copper layer. In FIG. 2(b), a photosensitive layer 30 and a support film 20 are formed on the conductor layer 40 of the substrate by the photosensitive layer-forming step. In FIG. 2(c), in the exposure step, the photosensitive layer 30 is irradiated with active rays 80 projecting an image of a photomask thereon through the support film 20 to form the photocured portions on the photosensitive layer 30. In FIG. 2(d), in the development step, a region other than the photocured portion formed in the exposure step is removed from the substrate to form a resist pattern 32 including the photocured portions on the substrate. In FIG. 2(e), a plating layer 60 is formed on the conductor layer 40 of the substrate not covered with the resist by the plating process using the resist pattern 32 including the photocured portions as a mask. In FIG. 2(f), the resist pattern 32 including the photocured portions is peeled off with a strongly alkaline aqueous solution, followed by removal of the conductor layer 40 masked with the resist pattern 32 by a flash etching process to form a conductor pattern 70 including a plating layer 62 after etching processing and a conductor layer 42 after etching processing. The conductor layer 40 and the plating layer 60 may contain the same material or different materials. In a case where the conductor layer 40 and the plating layer 60 may contain the same material, the conductor layer 40 and the plating layer 60 may be integrated. Note that, although the projection exposure method has been described with reference to FIG. 2, the resist pattern 32 may be formed using both a mask exposure method and an LDI exposure method.

Although the preferred embodiments of the present disclosure have been described in detail above, the present disclosure is not limited to the above-described embodiments.

### Examples

Hereinafter, the present disclosure will be more specifically described with reference to Examples, but the present disclosure is not limited to the following Examples.

### [Examples 1 and 2, and Comparative Examples 1 to 5]

### <Preparation of Photosensitive Resin Composition>

Next, the components illustrated in Table 1 below were mixed in the amount (unit: parts by mass) illustrated in the same table to obtain a photosensitive resin composition. The formulation amount of the components other than the solvent illustrated in Table 1 is the mass of the non-volatile content (solid content).

**[Table 1]**

| Component | Material | Formulation ratio (parts by mass) |
|---|---|---|
| (A) Binder polymer | A-1 | 57 |
| | B-1 | 34.5 |
| (B) Photopolymerizable compound | B-2 | 6 |
| | B-3 | 2.5 |
| (C) Photopolymerization initiator | C-1 | 5.5 |
| (D) Photosensitizer | D-1 | 0.027 |
| | E-1 | 0.77 |
| | E-2 | 0.05 |
| Other components | E-3 | 0.04 |
| | E-4 | 1 |
| | E-5 | 0.01 |
| | Methanol | 6 |
| Solvent | Toluene | 16 |
| | Acetone | 10 |

Details of each component illustrated in the table 1 are as follows.

### ((A) Binder Polymer)

A-1: Copolymer of methacrylic acid/styrene/2-hydroxyethyl methacrylate/benzyl methacrylate (mass ratio: 27/50/3/20, weight-average molecular weight: 35000) in methyl propylene glycol/toluene solution

### ((B) Photopolymerizable Compound)

B-1: 2,2-Bis(4-(methacryloxypentaethoxy)phenyl)propane (manufactured by Resonac Corporation, trade name: FA-321M, the number of EO groups: 10 (average value))
B-2: Ethoxylated bisphenol A dimethacrylate (the number of EO groups: 2.6 (average value)) (manufactured by Kyoeisha Chemical Co., Ltd., trade name: BP-2EM)
B-3: (PO)(EO)(PO)-modified polyethylene glycol dimethacrylate (manufactured by Resonac Corporation, trade name: FA-024M, the number of EO groups: 6 (average value), the number of PO groups: 12 (average value))

### ((C) Photopolymerization Initiator)

C-1:2-(O-chlorophenyl)-4, 5-diphenylbiimidazole (manufactured by Changzhou Qiangli Electronic New Material Co., Ltd.)

### ((D) Photosensitizer)

D-1: 1-Phenyl-3-(4-methoxystyryl)-5-(4-methoxyphenyl)pyrazoline (manufactured by Nippon Chemical Industrial Co., Ltd.)

### (Other Components)

E-1: Leucocrystal violet (manufactured by Yamada Chemical Co., Ltd.) (hydrogen donor)
E-2: Malachite green (manufactured by OSAKA ORGANIC CHEMICAL INDUSTRY LTD.) (dye)
E-3: tert-Butylcatechol (manufactured by FUJIFILM Wako Pure Chemical Corporation) (polymerization inhibitor)
E-4: Benzotriazole derivative (manufactured by Sanwa Kasei Co., Ltd., trade name: SF-808H (heterocyclic compound)
E-5: 2,2,6,6-Tetramethyl-4-hydroxypiperidine-1-oxyl (manufactured by ADEKA Corporation) (polymerization inhibitor)

### <Production of Photosensitive Element>

### (Preparation of Support Film)

As the support film of the photosensitive element, PET films having the surface roughnesses Sq₁ (surface roughness of the first surface) and Sq₂ (surface roughness of the second surface) illustrated in Table 2 were prepared. Each of the PET films has a thickness of 16 µm. In addition, it is illustrated in Table 2 whether a lubricant in the PET films of Examples and Comparative Examples is present or absent, and whether the lubricant is present on either the first surface or the second surface. The surface roughnesses Sq₁ and Sq₂ of the PET film were measured by a method described later.

A solution of the photosensitive resin composition was uniformly applied onto a surface that is the second surface of the PET film (support film). Thereafter, the PET film was dried by a hot air convection dryer at 90°C for 10 minutes to form a photosensitive layer having a film thickness of 25 µm after drying. Subsequently, a polyethylene film (trade name "NF-15 A" manufactured by Tamapoly Co., Ltd.) was laminated as a protective layer on the photosensitive layer to obtain a photosensitive element.

### <Measurement of Surface Roughnesses Sq₁ and Sq₂ of Support Film>

The support film (PET film) was peeled off from the photosensitive element, and surface shapes of the first surface and the second surface of the support film were measured with a scanning white-light interference microscope VS1540 (manufactured by Hitachi High-Tech Science Corporation, magnification: 50 times, measurement device: piezo, measurement mode: Plase, scan speed: 4 µm, visual field size: 128 µm × 128 µm, scan range: 3 to -3 µm, the number of effective pixels: 50). An image obtained was subjected to interpolation and 4th order surface correction, and Sq values calculated were defined as the surface roughness values of the support film. Note that, for the support film determined to be "scratched" in the evaluation of scratches described later, the surface roughnesses were measured for portions having no scratches (recessed portion or crack having a maximum length of 50 µm or more). In addition, it was confirmed that the value of the surface roughnesses measured by the above method were not changed from the values of the surface roughnesses in the support film in the initial state before the production of the photosensitive element.

### <Evaluation of Scratches of Support Film>

A support film of a 2 m² photosensitive element was irradiated with light emitted from an LED lamp, and the presence or absence of recessed portions or cracks having a maximum length of 50 µm or more on the first surface and the second surface of the support film was visually observed. A case where one or more recessed portions or cracks having a maximum length of 50 µm or more were observed on the first surface or the second surface of the support film was determined as "scratched", and a case where no recessed portions or no cracks was observed was determined as "not scratched". The results are illustrated in Table 2.

### <Evaluation of Smoothness of sidewall of Resist Pattern>

### (Production of Laminated Body)

A Cu sputtered PET film (manufactured by GEOMATEC Co., Ltd., plate thickness: 125 µm, Ra < 50 nm) as a substrate was heated to 80°C, and the photosensitive element was compression-bonded to the substrate so that the photosensitive layer was in contact with the copper surface while the protective layer was peeled off. The compression-bonding was performed using a heat roll at 110°C at a pressure of 0.40 MPa and a roll speed of 1.0 m/min. In this way, a laminated body in which the substrate, the photosensitive layer, and the support film were laminated in this order was obtained. The laminated body was used as a test piece of the following test. HLM-3000 (product name, manufactured by Taisei Laminator Co., Ltd.) was used as a laminator. Here, for the photosensitive element determined as "scratched" in the evaluation of scratches on the support film, the photosensitive element obtained by cutting out a portion having no scratches (recessed portion or crack having a maximum length of 50 µm or more) on the support film was used to prepare the laminated body.

### (Measurement of Minimum Developing Time)

The support film was peeled off from the test piece to expose the photosensitive layer, and a 1% by mass sodium carbonate aqueous solution at 30°C was sprayed. The time until the photosensitive layer was completely removed was measured and taken as the minimum development time.

### (Formation of Resist Pattern)

A glass chromium-type phototool (size: 9 cm × 9 cm, having a wiring pattern with a line width/space width of 5 µm/5 µm) as a negative was placed on the support film of the test piece, and the photosensitive layer was exposed at an exposure amount of 110 mJ/cm² by using a projection exposure apparatus (product name "UX-2240-SM-XJ01" manufactured by USHIO INC.) with an ultra-high pressure mercury lamp (365 nm) as a light source. After the exposure, the support film was peeled off, and a 1% by mass of sodium carbonate aqueous solution at 30°C was sprayed to the exposed photosensitive layer for a time of twice the shortest development time, and the unexposed portion was removed to form a resist pattern.

### (Measurement of LER)

The LER (line edge roughness) of the resist pattern formed by the above-described method was measured by the following method.

That is, a region where a resist pattern having a line width/space width of 5 µm/5 µm was formed was imaged by using a Computer Numerical Control image measurement system (product name "NEXIV VMZ-R4540" manufactured by Nikon Corporation). In the scanning measurement of NEXIV VMZ-R4540, the contour of the resist pattern on the substrate was specified, and the coordinates of the contour of the resist pattern were measured for 6 lines of the resist pattern. In the measurement of the coordinates, 260 coordinates along a length of 52 µm, engraved at intervals of 0.2 µm, were measured for each of the contour on one side and the contour on the other side of the line. In addition, these measurements were performed at 3 locations for each of the 6 lines. Thus, a total coordinate of 9360 points were measured. Then, a variation (3σ) in the contour of the resist pattern was calculated based on the measured coordinates of 9360 points. σ is a standard deviation, and 3σ of the contour of the resist pattern is an LER (line edge roughness). The smaller the LER, the higher the smoothness of the sidewall of the resist pattern. The results are illustrated in Table 2.

### <Evaluation of Defects on Resist Pattern>

For the photosensitive element determined as "scratched" in the evaluation of scratches on the support film, a resist pattern was formed in the same manner as that for the evaluation of the smoothness of the sidewall of the resist pattern, except that the photosensitive element obtained by cutting out a portion having scratches (recessed portion or crack having a maximum length of 50 µm or more) on the support film was used. For the formed resist pattern, the presence or absence of defects was visually observed. Here, the defects mean defects of the resist pattern that can be visually observed. The results are illustrated in Table 2.

**[Table 2]**

| | | | Examples | | Comparative Examples | | | | |
|---|---|---|---|---|---|---|---|---|---|
| | | | 1 | 2 | 1 | 2 | 3 | 4 | 5 |
| | Sq₁ of first surface (nm) | | 3.6 | 3.7 | 3.7 | 3.8 | 4.8 | 5.3 | 5.4 |
| | Sq₂ of second surface (nm) | | 5.9 | 5.4 | 3.9 | 4.9 | 3.9 | 3.8 | 4.4 |
| Support film | Sq₁ + Sq₂(nm) | | 9.5 | 9.1 | 7.6 | 8.7 | 8.7 | 9.1 | 9.8 |
| | Lubricant | Presence or absence | Presence | Presence | Absence | Presence | Presence | Presence | Presence |
| | | Present position | Second surface | Second surface | - | Second surface | First surface | First surface | Both surfaces |
| LER (nm) | | | 66 | 39 | 63 | 66 | 138 | 144 | 162 |
| Presence or absence of scratches on support film | | | Absence | Absence | Presence | Presence | Presence | Absence | Absence |
| Presence or absence of defects on resist pattern | | | Absence | Absence | Presence | Presence | Presence | Absence | Absence |

### Reference Signs List

1: photosensitive element, 2, 20: support film, 3, 30: photosensitive layer, 4: protective layer, 32: resist pattern, 40: conductor layer, 42: conductor layer after etching process, 50: insulating layer, 60: plating layer, 62: plating layer after etching process, 70: conductor pattern, 80: active ray.

## Claims

1. A method for producing a photosensitive element comprising:
a step of forming a photosensitive layer on a support film by using a photosensitive resin composition, wherein
in a case where a surface of the support film opposite to a surface of the support film on which the photosensitive layer is formed is defined as a first surface, and the surface of the support film on which the photosensitive layer is formed is defined as a second surface,
a surface roughness Sq₁ of the first surface is 4.0 nm or less, and
a total value of the surface roughness Sq₁ of the first surface and a surface roughness Sq₂ of the second surface, Sq₁ + Sq₂, is 9.0 nm or more.

2. The method for producing a photosensitive element according to claim 1, wherein Sq₁ + Sq₂ is 12.0 nm or less.

3. The method for producing a photosensitive element according to claim 1, wherein Sq₂ - Sq₁ is 1.0 nm or more.

4. A photosensitive element comprising:
a support film; and
a photosensitive layer, wherein
in a case where a surface of the support film opposite to a surface of the support film on which the photosensitive layer is formed is defined as a first surface, and the surface of the support film on which the photosensitive layer is formed is defined as a second surface,
a surface roughness Sq₁ of the first surface is 4.0 nm or less, and
a total value of the surface roughness Sq₁ of the first surface and a surface roughness Sq₂ of the second surface, Sq₁ + Sq₂, is 9.0 nm or more.

5. The photosensitive element according to claim 4, wherein Sq₁ + Sq₂ is 12.0 nm or less.

6. The photosensitive element according to claim 4, wherein Sq₂ - Sq₁ is 1.0 nm or more.

7. The photosensitive element according to claim 4, wherein in a case where the support film of the photosensitive element is irradiated with light, and a smaller area of an entire area of the support film and a 2 m² area of the support film is observed, no recessed portion or crack having a maximum length of 50 µm or more is observed on both the first surface and the second surface of the support film.

8. A method for forming a resist pattern, the method comprising:
a step of arranging a photosensitive layer and a support film on a substrate in this order from the substrate, using the photosensitive element according to any one of claims 4 to 7;
a step of exposing the photosensitive layer to an active ray through the support film; and
a step of removing the support film and thereafter removing an uncured portion of the photosensitive layer from the substrate.

9. A method for producing a printed wiring board, the method comprising a step of performing an etching process or a plating process on a substrate on which a resist pattern is formed by the method for forming a resist pattern according to claim 8 to form a conductor pattern.
